# EUROPEAN PATENT SPECIFICATION

(11) **EP 4 329 453 B1**
(45) Date of publication and mention of the grant of the patent: **28.05.2025**
(21) Application number: 22793370.2
(22) Date of filing: 30.07.2022
(51) Int. Cl.: H01L 21/306, H10B 12/00, H01L 21/768

(54) **MANUFACTURING METHOD FOR SEMICONDUCTOR STRUCTURE**
VERFAHREN ZUR HERSTELLUNG EINER HALBLEITERSTRUKTUR
PROCÉDÉ DE FABRICATION POUR STRUCTURE À SEMI-CONDUCTEURS

(30) Priority: 12.07.2022 CN 202210818531
(43) Date of publication of application: 28.02.2024
(73) Proprietor: Changxin Memory Technologies, Inc., Hefei, Anhui 230601 (CN)
(72) Inventor: LIAN, Ting, Hefei, Anhui 230601 (CN); LIU, Yuheng, Hefei, Anhui 230601 (CN); FU, Yunfei, Hefei, Anhui 230601 (CN); KUANG, Dingdong, Hefei, Anhui 230601 (CN)
(74) Representative: Lavoix
(86) International application number: PCT/CN2022/109285
(87) International publication number: WO 2024/011673

(56) References cited:
- CN-A- 105 719 956
- CN-A- 105 719 956
- CN-A- 112 542 381
- CN-A- 112 928 069
- CN-A- 113 192 958
- CN-A- 113 471 148
- CN-A- 113 597 662
- CN-A- 114 334 981
- JP-A- H06 204 244
- US-A1- 2002 197 509
- US-A1- 2009 087 968
- US-A1- 2017 178 922
- US-A1- 2020 135 485
- US-A1- 2020 135 485
- US-A1- 2022 084 967
- US-A1- 2022 392 772

## Description

### TECHNICAL FIELD

Embodiments of the disclosure relate to the field of semiconductors, and in particular to a method for manufacturing a semiconductor structure.

### BACKGROUND

With the shrink in size of the geometric pattern in a semiconductor device, higher requirements are needed for the precision of a patterning treatment during a semiconductor process. In a process for manufacturing a semiconductor structure, factors that affect the precision of the patterning treatment include the alignment precision between a mask layer and a photomask, and the etching selectivity between the mask layer and a substrate to be etched. The greater the etching selectivity between the mask layer and the substrate, the more favorable the pattern is to be transferred to the substrate through the mask layer during the etching process. In addition, the optical properties of the mask layer itself may affect the alignment precision between the mask layer and the photomask. Background may be found in CN105719956A and US20170178922A1.

### SUMMARY

Embodiments of the disclosure provide a semiconductor structure and a method for manufacturing the same, which are at least beneficial for improving the patterning precision of a substrate and an initial mask layer.

The invention is set out in the appended set of claims

### BRIEF DESCRIPTION OF THE DRAWINGS

One or more embodiments are exemplarily descripted by the corresponding figures in the drawings. These exemplary descriptions do not constitute the limitation to the embodiments. Unless otherwise stated, the figures in the drawings do not constitute a scale limitation. In order to more clearly illustrate the technical solutions of the embodiments of the disclosure and the technical solutions of the related art, the drawings used in the description of the embodiments will be briefly descripted herein below. Apparently, the drawings in the following description only relate to some embodiments of this disclosure. For an ordinary person skilled in the art, other drawings can be obtained according to these drawings without creative efforts.
FIG. 1 shows a flowchart of a method for manufacturing a semiconductor structure provided by embodiments of the disclosure.
FIG. 2 to FIG. 8 schematically show structures corresponding to operations of a method for manufacturing a semiconductor structure provided by embodiments of the disclosure.
FIG. 9 shows a relationship between a content of boron and an extinction coefficient of the initial mask layer in a method for manufacturing a semiconductor structure provided by embodiments of the disclosure.

### DETAILED DESCRIPTION

Embodiments of the disclosure provide a method for manufacturing a semiconductor structure. On the one hand, P-type doping a semiconductor layer is beneficial to improving the optical properties of the initial mask layer, and then is beneficial to improving the alignment precision between the initial mask layer and the photomask when an irradiation alignment is subsequently performed on the initial mask layer by using the photomask. In addition, the improvement of the alignment precision between the initial mask layer and the photomask is beneficial to improving the precision of the first patterning when the first patterning treatment is subsequently performed on the initial mask layer. That is, the pattern of the photomask can be more accurately transferred to the initial mask layer, so as to form the mask layer that meets the requirements. On the other hand, the mask layer is also the P-type doped semiconductor layer, which is beneficial to reducing the etching rate of the mask layer during an etching process when the substrate is subsequently etched. As a result, in the step of performing the second patterning on the substrate by taking the mask layer as the mask and using the etching process, on the premise of ensuring that the etching rate of the substrate is greater than the etching rate of the mask layer in the etching process, it is beneficial to increase the difference between the etching rate of the substrate and the etching rate of the mask layer during the etching process, which facilitates the accurate transfer of the pattern to the substrate through the mask layer, thereby improving the precision of the second patterning treatment. In this way, the patterning precision of the initial mask layer and the substrate can be improved, so that the accuracy of final transfer of the pattern in the photomask to the substrate can be increased, thereby forming a semiconductor structure with a higher dimensional precision.

The embodiments of the disclosure are described in detail below with reference to the accompanying drawings. However, an ordinary person skilled in the art can understand that in the embodiments of the disclosure, many technical details are provided in order to make readers better understand the embodiments of the disclosure. However, even without these technical details, and variations and modifications based on the following embodiments, the technical solutions claimed by the embodiments of the disclosure can be realized.

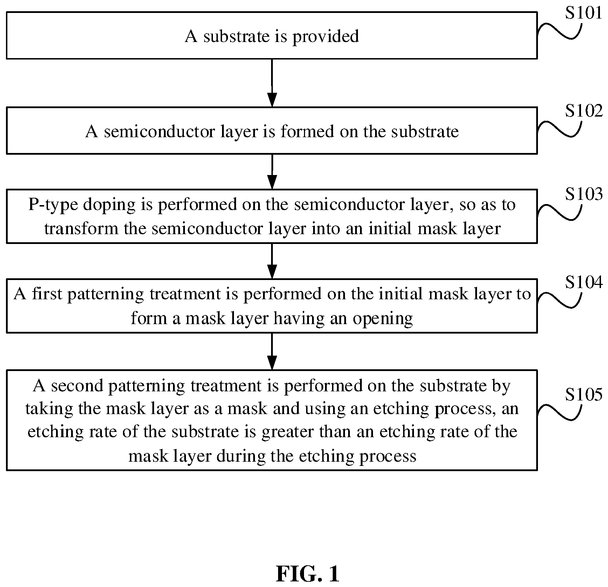

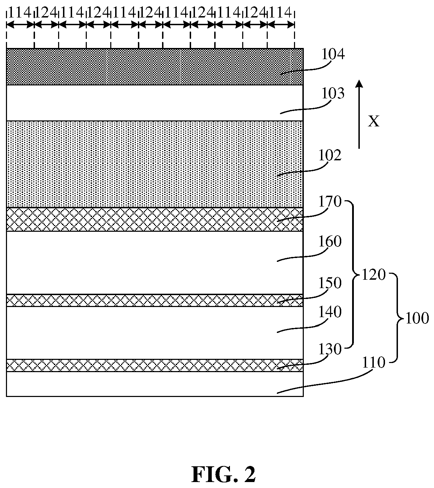

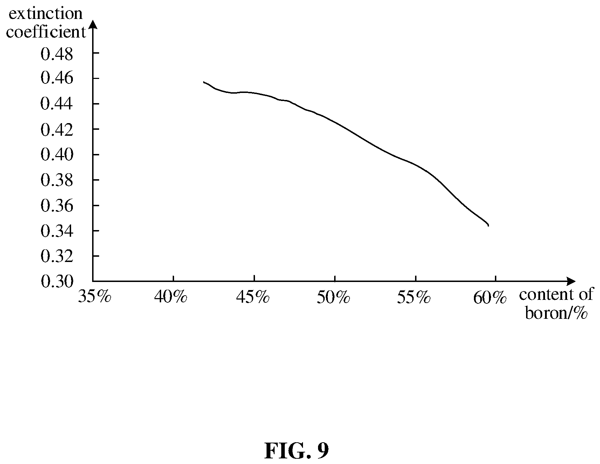

Embodiments of the disclosure provide a method for manufacturing a semiconductor structure. The method for manufacturing a semiconductor structure provided by the embodiments of the disclosure is described in detail below with reference to the accompanying drawings. FIG. 1 shows a flowchart of a method for manufacturing a semiconductor structure provided by embodiments of the disclosure. FIG. 2 to FIG. 8 schematically show structures corresponding to operations of a method for manufacturing a semiconductor structure provided by embodiments of the disclosure. FIG. 9 shows a relationship between a content of boron and an extinction coefficient of the initial mask layer in a method for manufacturing a semiconductor structure provided by embodiments of the disclosure. It should be noted that, in order to facilitate description and clearly illustrate the operations of the method for manufacturing a semiconductor structure, FIG. 2 to FIG. 8 schematically show partial structures of the semiconductor structure in the embodiments.

Referring to FIG. 1 to FIG. 9, the method for manufacturing a semiconductor structure may include the following operations.

At S101, referring to FIG. 2, a substrate 100 is provided.

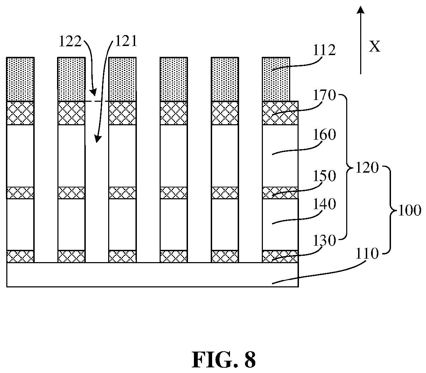

In some embodiments, referring to FIG. 2, providing the substrate 100 may include the following operations. A base 110 is provided. A stacked structure 120 is formed on the base 110, and is configured to form a capacitor contact hole 121 (referring to FIG. 8). Performing a second patterning treatment on the substrate 100 may include an operation of etching the stacked structure 120 by taking the mask layer 112 as a mask and using an etching process, so as to form the capacitor contact hole 121.

In some embodiments, after forming the capacitor contact hole 121, the method for manufacturing a semiconductor structure further includes an operation of forming a capacitor structure on the basis of the capacitor contact hole 121. It should be noted that, a process for manufacturing the capacitor structure is not specifically limited in the embodiments of the disclosure. In an example, the base 110 includes a transistor structure and the capacitor contact hole 121 exposes the source or the drain of the transistor structure, such that the capacitor structure is contacted with and electrically connected with the source or the drain of the transistor.

It can be understood that, the capacitor structure formed subsequently by using the capacitor contact hole 121 generally needs to have a greater aspect ratio to ensure that the capacitor structure has a higher capacitance. Therefore, forming the stacked structure 120 on the substrate 110 on the one hand, is beneficial to increasing the depth of the capacitor structure formed subsequently in the direction from the substrate 113 to the stacked structure 120, thereby improving the aspect ratio of the capacitor structure; on the other hand, part of film layers of the stacked structure 120 can be used subsequently as a support layer when the capacitor contact hole 121 is used to form the capacitor structure, so as to avoid a collapse of the capacitor structure with the greater aspect ratio and improve the stability of the semiconductor structure.

In some embodiments, the base 110 may be a silicon base, a germanium base, a silicon germanium base, a silicon carbide base, or a silicon-on-insulator base, etc.

In some embodiments, still referring to FIG. 1, forming the stacked structure 120 may include an operation of forming a bottom support layer 130, a first dielectric layer 140, an intermediate support layer 150, a second dielectric layer 160 and a top support layer 170 stacked in sequence on the base 110.

In an example, the bottom support layer 130, the intermediate support layer 150 and the top support layer 170 may have the same the materials. For example, the materials of the bottom support layer 130, the intermediate support layer 150, and the top support layer 170 may all be silicon nitride. The materials of the first dielectric layer 140 and the second dielectric layer 160 may be the same. For example, the materials of the first dielectric layer 140 and the second dielectric layer 160 may all be silicon oxide.

It should be noted that, the bottom support layer 130, the intermediate support layer 150 and the top support layer 170 are shown in the same shaded manner in FIG. 2 and FIG. 6 to FIG. 8, which does not mean that the bottom support layer 130, the intermediate support layer 150 and the top support layer 170 have the same materials. In practical applications, the materials of the bottom support layer 130, the intermediate support layer 150 and the top support layer 170 may be different.

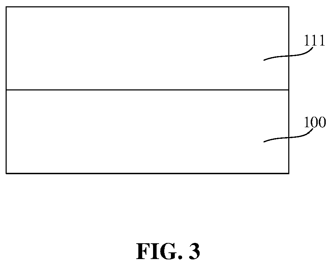

At S102, referring to FIG. 3 to FIG. 4, a semiconductor layer 101 is formed on the substrate 100.

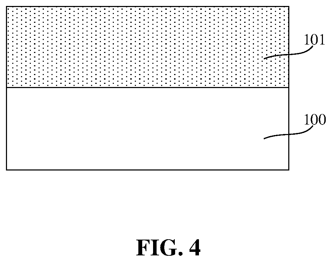

In some embodiments, forming the semiconductor layer 101 may include the following operations. Referring to FIG. 3, an initial semiconductor layer 111 is formed on the substrate 100. Referring to FIG. 4, N-type doping or P-type doping is performed on the initial semiconductor layer 111 to transform the initial semiconductor layer 111 into the semiconductor layer 101.

In some embodiments, the material of the initial semiconductor layer 111 may be silicon.

In an example, N-type doping is performed on the initial semiconductor layer 111. That is, an N-type doping element is implanted into the initial semiconductor layer 11. The N-type doping element may be at least one of arsenic, phosphorus or antimony.

In another example, P-type doping is performed on the initial semiconductor layer 111. That is, a P-type doping element is implanted into the initial semiconductor layer 11. The P-type doping element may be at least one of boron, indium or gallium.

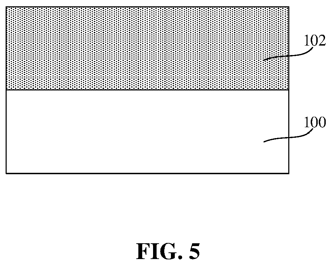

At S103, referring to FIG. 5, P-type doping is performed on the semiconductor layer 101 to transform the semiconductor layer 101 into an initial mask layer 102. Performing P-type doping on the semiconductor layer 101 means implanting the P-type doping element into the semiconductor layer 101.

In an example, P-type doping of the semiconductor layer 101 may be performed by implanting boron into the semiconductor layer 101.

It should be noted that, for the simplicity of the illustration, FIG. 3 to FIG. 5 just show the substrate 100, while the structure included in the substrate 100 is shown in FIG. 2.

The material of the initial mask layer 102 includes a boron-silicon compound, and an atomic percent of boron atoms and silicon atoms in the boron-silicon compound is in a range of 1:1 to 3:2.

It can be understood that, referring to FIG. 9, the extinction coefficient of the boron-silicon compound decreases with the increase of the content of boron atoms in the boron-silicon compound. Therefore, increasing the content of boron atoms in the initial mask layer 102 is beneficial to reducing the extinction coefficient of the initial mask layer 102. That is, the initial mask layer 102 is rendered more light-transmitting. In addition, the content of boron atoms in the initial mask layer 102 determines the content of boron atoms in the mask layer 112 formed subsequently. The content of boron atoms in the mask layer 112 may have influence on the etching rate of the mask layer 112 during the etching process for etching the substrate 100. Therefore, it is necessary to comprehensively consider the influence of the content of boron atoms in the mask layer 112 on the extinction coefficient of the mask layer 112 and the etching rate of the mask layer112 during the etching process. By controlling the atomic ratio between silicon atoms and boron atoms in the borosilicate compound in the range of 1:1 to 3:2, it is beneficial to reduce the extinction coefficient of the initial mask layer 102, while reducing the etching rate of the mask layer 112 in the etching process for etching the substrate 100.

In some embodiments, still referring to FIG. 9, the extinction coefficient of the initial mask layer 102 may be less than 0.45. It can be understood that, when the extinction coefficient of the initial mask layer 102 is less than 0.45, the initial mask layer 102 has good light-transmitting. In some embodiments, the initial mask layer 102 and the substrate 100 are provided with a photolithography mark, respectively to increase the light-transmitting of the initial mask layer 102, so as to facilitate that the photolithography mark of the initial mask layer 102 is overlapped with the lithography mark of the substrate 100 through the initial mask layer 102 in step of irradiating, achieving the alignment precision between the initial mask layer 102 and the substrate 100. It can be understood that, the extinction coefficient of the initial mask layer 102 is less than 0.45, which is beneficial to improving the alignment precision between the initial mask layer 102 and the substrate 100, and is beneficial to forming the capacitor contact hole 121 at a preset position (referring to FIG. 8) when performing subsequently the second patterning treatment, i.e., improving the precision of the second patterning treatment.

In some embodiments, the extinction coefficient of the initial mask layer may be in a range of 0.34 to 0.44. According to the above analysis, when the extinction coefficient of the initial mask layer 102 is in the range of 0.34 to 0.44, the extinction coefficient of the initial mask layer 102 is low, and under this range, the content of boron atoms in the boron-silicon compound is beneficial to reducing the etching rate of the mask layer 112 in the etching process for etching the substrate 100. Therefore, while ensuring that the initial mask layer 102 has a low the extinction coefficient, the ratio of the etching rate of the substrate to the etching rate of the mask layer 112 in the same etching process is increased, thereby improving the precision of the first patterning treatment and the second patterning treatment.

In one example, the material of the initial mask layer 102 is the boron-silicon compound, and the atomic percent of boron atoms and silicon atoms in the boron-silicon compound is 3:2, and the extinction coefficient of the initial mask layer 102 is 0.34.

In some embodiments, the initial mask layer 102 is provided with the photolithography mark. In the operation of performing the first patterning treatment on the initial mask layer 102 by using a first etching process, the method for manufacturing a semiconductor structure further includes an operation of providing a photomask with an opening and a photolithography mark. The photolithography mark of the photomask is overlapped with the photolithography mark of the initial mask layer 102.

It can be understood that, when the extinction coefficient of initial mask layer 102 is less than 0.45, the initial mask layer 102 has good light-transmitting, which is beneficial for an operator to observe the photolithography mark of the initial mask layer 102 and the photolithography mark of the photomask, thereby facilitating the alignment between the photolithography mark of the initial mask layer 102 and the photolithography mark of the photomask. That is, the orthographic projection of the photolithography mark of the initial mask layer 102 on the substrate 100 is overlapped with the orthographic projection of the photolithography mark of the photomask on the substrate 100. In this way, an opening 122 is aligned with part of the initial mask layer 102 that needs to be etched, thereby improving the precision of the first patterning treatment on the initial mask layer 102.

In some embodiments, the initial mask layer 102 has a thickness in a range of 400 nm to 460 nm along a direction X from the substrate 100 to the initial mask layer 102.

It can be seen from the foregoing description that, the initial mask layer 102 is formed by the P-type doped semiconductor layer, and the mask layer 112 formed by the initial mask layer 102 upon the first patterning treatment subsequently is also formed by the P-type doped semiconductor layer. In this way, it is beneficial to reduce the etching rate of the mask layer 112 in the etching process for etching subsequently the substrate 100. It can be understood that, in order to increase the capacitance of the capacitor structure formed subsequently, the substrate 100 has a greater thickness along the direction X from the substrate 100 to the initial mask layer 102, so the etching time required for the second patterning treatment on the substrate 100 is relatively long. Under this situation, the mask layer 112 used as a mask may also be consumed due to etching in the step of the second patterning treatment. Therefore, reducing the etching rate of the mask layer 112 in the etching process is beneficial to reducing the etching thickness of the mask layer 112 in the step of the second patterning treatment.

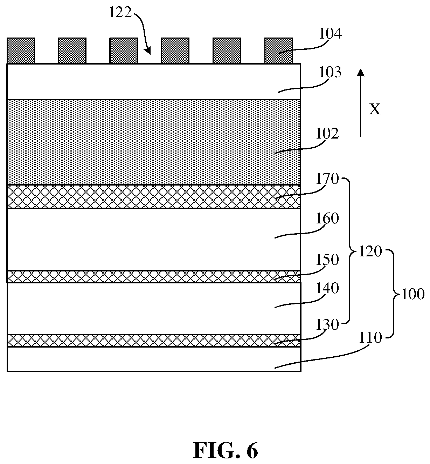

It can be understood that, referring to FIG. 6 to FIG. 8, on the premise of reducing the etching thickness of the mask layer 112 in the step of the second patterning treatment, the initial mask layer 102 may have a lower thickness in the direction X when forming, and then the mask layer 112 formed subsequently may also have a lower thickness in the direction X. In this way, the aspect ratio of the opening 122 of the mask layer 112 can be reduced, so that etching materials used in the etching process is more prone to etch the substrate 100 via the opening 122. Therefore, in the step of the second patterning treatment, the aspect ratio of the formed trench can be reduced, so that the second patterning treatment on the substrate 100 by the etching process can be improved, thereby increasing the precision of the second patterning treatment. It should be noted that, the final morphology of the trench formed in the step of the second patterning treatment is composed of the opening 122 of the mask layer 112 and the capacitor contact hole 121 of the substrate 100.

In an example, when performing a second patterning treatment on a substrate 100 having the same size, in order to form a capacitor contact hole 121 with the same size, an initial mask layer formed by a semiconductor layer without P-type doping is required to have the thickness of 500 nm. In contrast, the thickness of the initial mask layer 102 formed by the P-type doped semiconductor layer may be 450 nm in the embodiment of the disclosure. It can be seen that, the initial mask layer 102 formed by P-type doped semiconductor layer can reduce the etching rate of the mask layer 112 in the subsequent etching process for etching the substrate 100, which facilitates to reduce the thickness of the initial mask layer 102 to be formed, thereby reducing the difficulty and improving the precision of second patterning treatment.

At S104, referring to FIG. 2, FIG. 6 and FIG. 7, a first patterning treatment is performed on the initial mask layer 102 to form a mask layer 112 with an opening 122.

It can be understood that, the step of performing the first patterning on the initial mask layer 102 further includes the following operations. A photomask with an opening is provided. The initial mask layer 102 is irradiated through the photomask to form the mask layer 112 with the opening 122. Performing P-type doping on the semiconductor layer is beneficial to reducing the extinction coefficient of the initial mask layer 102, which improves the alignment precision between the initial mask layer 102 and the photomask, thereby improving the precision of the first patterning treatment. That is, the pattern of the photomask is more accurately transferred to the initial mask layer 102, to form the mask layer 112 that meets the requirements. It should be noted that the pattern of the photomask refers to the pattern formed by openings of the photomask.

In some embodiments, after forming the initial mask layer 102 on the substrate 100 and prior to performing the first patterning treatment on the initial mask layer 102, the method for manufacturing a semiconductor structure may further include the following operations.

Referring to FIG. 2, a first mask layer 103 and a second mask layer 104 stacked on a side, away from the substrate 100 of the initial mask layer 102 are formed in sequence. The second mask layer 104 includes a first region 114 and a second region 124 adjacent to each other. The second region 124 is used to form the opening 122 via a subsequent etching.

In an example, the material of the first mask layer 103 may be silicon oxide, and the material of the second mask layer 104 may be amorphous carbon.

It should be noted that, the first mask layer 103 and the second mask layer 104 are provided with a lithography mark, and have good light-transmitting respectively. Therefore, on the basis of improving the light-transmitting of the initial mask layer 102 in the embodiments of the disclosure, it is beneficial for an operator to align the photolithography mark of the first mask layer 103, the photolithography mark of the second mask layer 104 and the photolithography mark of the initial mask layer on 102, thereby improving the precision of the first patterning treatment.

Referring to FIG. 2 and FIG. 6 in combination, the second region 124 is irradiated with the photomask to change the film properties of the irradiated second region 124. The first region 114 and the second region 124 are etched by the same etching process, and the etching rate of the first region 114 is less than the etching rate of the second region 124 during the etching process. Therefore, when removing the region 114, part of the second region 124 is retained, so as to form the second mask layer 104 with the opening 122.

It should be noted that, in the step of etching the second mask layer 104, both the first region 114 and the second region 124 are etched. However, because the second region 124 has been subjected with the irradiating treatment, the etching rate of the first region 114 is less than the etching rate of the second region 124 during the etching process, thereby forming the second mask layer 104 with the opening 12.

In some embodiments, the step of performing the first patterning treatment on the initial mask layer 102 includes the following operations. Referring to FIG. 6 to FIG. 8 in combination, the first mask layer 103 is etched by taking the second mask layer 104 with the opening 122 as a mask to form the first mask layer 103 with the opening 122. The initial mask layer 102 is etched by taking the first mask layer 103 with the opening 122 as a mask.

It should be noted that, in some embodiments, in the step of etching the first mask layer 103 by taking the second mask layer 104 with the opening 122 as the mask, the second mask layer 104 is also etched. When the first mask layer 103 with the opening 122 is formed, the second mask layer 104 is completely etched. In other embodiments, in the step of etching the first mask layer 103 by taking the second mask layer 104 with the opening 122 as the mask, the second mask layer 104 is completely etched and part of the first mask layer 103 not exposed by the opening 122 of the second mask layer 104 is etched, so that the thickness of the first mask layer 103 with the opening 122 in the direction X is less than the thickness of the first mask layer 103 before performing the first patterning treatment.

In addition, in some embodiments, in the step of etching the initial mask layer 102 by taking the first mask layer 103 with the opening 122 as the mask, the first mask layer 103 is also etched. When the mask layer 112 with the opening 122 is formed, the first mask layer 103 is completely etched. In other embodiments, in the step of etching the initial mask layer 102 by taking the first mask layer 103 with the opening 122 as the mask, the first mask layer 103 is completely etched away and part of the initial mask layer 102 not exposed by the opening 122 of first mask layer 103 is etched, so that the thickness of the mask layer 112 with the opening 122 in the direction X is less than the thickness of the initial mask layer 102 before performing the first patterning treatment.

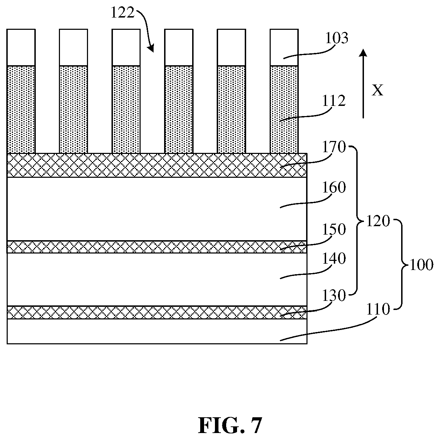

At S105, referring to FIG. 7 and FIG. 8, a second patterning treatment is performed on the substrate 100 by using an etching process with the mask layer 112 as a mask. The etching rate of the substrate 100 is greater than the etching rate of the mask layer 112 during the etching process.

It can be understood that, in the step of performing the second patterning treatment on the substrate 100 by using the etching process, the mask layer 112 is also etched in the etching process. As the mask layer 112 is formed by the P-type doped semiconductor layer, the etching rate of the mask layer 112 during the etching process can be reduced when the substrate 100 is etched. As a result, in the step of performing the second patterning treatment on the substrate 100 by using the etching process with the mask layer 112 as the mask, on the premise of ensuring that the etching rate of the substrate 100 is greater than the etching rate of the mask layer 112 during the etching process, the difference between the etching rate of the substrate 100 and the etching rate of the mask layer 112 can be increased during the etching process, so that it is beneficial to accurately transfer the pattern formed by the opening 122 of the mask layer 112 to the substrate through the mask layer 112, thereby improving the precision of the second patterning treatment.

In addition, the manufacturing method provided by the embodiments of the disclosure is beneficial to increasing the difference between the etching rate of the substrate 100 and the etching rate of the mask layer 112 during the etching process, which facilitates to avoid over-etching of the mask layer 112 at a sidewall of the opening 122 of the formed mask layer 112, and thus to avoid the change of the size of capacitor contact hole 121 formed on the basis of the opening 122 is avoided, thereby ensuring the precision of the second patterning performed on the substrate 100.

In some embodiments, after performing the second patterning treatment on the substrate 100 by using the etching process, part of the mask layer 112 is retained, and a ratio of the thickness of the retained mask layer 112 and the thickness of the initial mask layer 102 along the direction from the substrate 100 to the initial mask layer 102 is in a range of 0.13 to 0.16. It can be understood that, in practical applications, after forming the capacitor contact hole 121 by etching the substrate 100, the remaining mask layer 112 may be removed.

It can be understood that, in the step of performing the second patterning treatment on the substrate 100 by adopting the etching process, it is necessary to retain part of the mask layer 112 to protect the substrate 100 that does not need to be etched, so as to improve the precision of the formed capacitor contact hole 121.

In addition, in the step of transforming the formed initial mask layer 102 into the mask layer 112 with the opening 122, the initial mask layer may be consumed with part of its thickness. In the step of etching the substrate 100, the mask layer 112 composed of the retained initial mask layer 102 may also be consumed. In this case, along the direction X from the substrate 100 to the initial mask layer 102, the thickness of the initial mask layer is in a range of 400 nm to 460 nm, which is beneficial that after performing the first patterning treatment on the initial mask layer 102 and the second patterning treatment on the mask layer 112, the ratio of the thickness of the retained mask layer 112 to the thickness of the initial mask layer 102 is in the range of 0.13 to 0.16. On the one hand, when the thickness of the initial mask layer 102 is less than 400 nm, in the step of performing the second patterning on the substrate 100, the mask layer 112 may be completely etched before the capacitor contact hole 121 is formed, so that the substrate 100 that does not need to be subjected to the second patterning treatment is etched, which affects the size of the finally formed capacitor contact hole 121. On the other hand, when the thickness of the initial mask layer 102 is less than 460nm, the formed trench would have a greater aspect ratio of greater in the step of performing the second patterning on the substrate 100, which increases the difficulty of performing the second patterning treatment on the substrate 100 and reduces the precision of the second patterning treatment. Therefore, in the embodiments of the disclosure, the thickness of the initial mask layer 102 is controlled in the range of 400 nm to 460 nm, and the ratio of the thickness of the retained mask layer 112 to the thickness of the initial mask layer 102 is controlled in the range of 0.13 to 0.16, which reduces the difficulty of the second patterning treatment, while ensuring that when the capacitor contact hole 121 is formed, the mask layer with part of its thickness is retained.

In some embodiments, the retained mask layer 112 may have the thickness of 65 nm to 75 nm along the direction X from the substrate 100 to the initial mask layer 102. In an example, the retained mask layer 112 has the thickness of 71 nm along the direction X from the substrate 100 to the initial mask layer 102.

In summary, in the manufacturing method provided by the embodiments of the disclosure, by P-type doping a semiconductor layer, on the one hand, it is beneficial to improve the optical properties of the initial mask layer 102. When an irradiation alignment is subsequently performed on the initial mask layer 102 by using the photomask, it is beneficial to improve the alignment precision between the initial mask layer 102 and the photomask. When the first patterning treatment is subsequently performed on the initial mask layer 102, the improvement of the alignment precision between the initial mask layer 102 and the photomask is beneficial to improving the precision of the first patterning treatment. That is, it is beneficial to more accurately transfer the pattern of the photomask to the initial mask layer 102, so as to form the mask layer 112 that meets the requirements. On the other hand, it is beneficial to reduce the etching rate of the mask layer 112 in the etching process when etching the substrate 100. Therefore, in the operation of performing the second patterning treatment, it is beneficial to increase the difference between the etching rate of the substrate 100 and the etching rate of the mask layer 112 in the etching process, so that it is beneficial to accurately transfer the pattern to the substrate 100 with the mask layer 112, thereby improving the precision of the second patterning treatment. In this way, it is beneficial to improve the patterning precision of the initial mask layer 102 and the substrate 100, so as to improve the accuracy of finally transferring the pattern of the photomask to the substrate 100, thereby forming the semiconductor structure with the higher dimensional precision.

## Claims

1. A method for manufacturing a semiconductor structure, comprising:
providing a substrate (100);
forming a semiconductor layer (101) on the substrate (100);
performing P-type doping on the semiconductor layer (101) to transform the semiconductor layer (101) into an initial mask layer (102);
performing a first patterning treatment on the initial mask layer (102) to form a mask layer (112) with an opening;
and performing a second patterning treatment on the substrate (100) by using an etching process with the mask layer (112) as a mask, wherein an etching rate of the substrate (100) is greater than an etching rate of the mask layer (112) during the etching process; wherein
a material of the initial mask layer (102) comprises a boron-silicon compound, and an atomic percent of boron atoms and silicon atoms in the boron-silicon compound is in a range of 1:1 to 3:2;
wherein providing the substrate (100) comprises:
providing a base (110);
forming a stacked structure (120) on the base (110), wherein the stacked structure (110) includes a bottom support layer (130), a first dielectric layer (140), an intermediate support layer (150), a second dielectric layer (160) and a top support layer (170) stacked in sequence on the base (110); and
performing the second patterning treatment on the substrate (100) comprises:
etching the stacked structure (120) by taking the mask layer (112) as a mask and using the etching process to form a capacitor contact hole (121).

2. The method according to claim 1, wherein
the initial mask layer (102) has an extinction coefficient of less than 0.45.

3. The method according to claim 2, wherein
the extinction coefficient of the initial mask layer (102) is in a range of 0.34 to 0.44.

4. The method according to claim 1, wherein
the initial mask layer (102) has a thickness ranging from 400 nm to 460 nm along a direction from the substrate (100) to the initial mask layer (102).

5. The method according to claim 1, wherein
after performing the second patterning treatment on the substrate (100) by using the etching process, part of the mask layer is retained, and a ratio of a thickness of the retained mask layer (112) to a thickness of the initial mask layer (112) along a direction from the substrate (100) to the initial mask layer (102) is in a range of 0.13 to 0.16.

6. The method according to claim 5, wherein
the thickness of the retained mask layer (112) is in a range of 65 nm to 75 nm along the direction from the substrate (100) to the initial mask layer (102).

7. The method according to claim 1, wherein
forming the semiconductor layer (101) comprises: forming an initial semiconductor layer (111) on the substrate (100); and performing N-type doping or P-type doping on the initial semiconductor layer (111) to transform the initial semiconductor layer (111) into the semiconductor layer (101).

8. The method according to claim 1, wherein
the initial mask layer (102) is provided with a photolithography mark, wherein during the first patterning treatment on the initial mask layer (102) by using a first etching process, the method further comprises: providing a photomask having the opening and the photolithography mark, wherein the photolithography mark of the photomask is overlapped with the photolithography mark of the initial mask layer (102).

9. The method according to claim 8, wherein
after forming the initial mask layer (102) on the substrate (100) and before performing the first patterning treatment on the initial mask layer (102), the method further comprises: forming a first mask layer (103) and a second mask layer (104) stacked in sequence at a side, away from the substrate (100), of the initial mask layer (102), wherein the second mask layer comprises a first region (114) and a second region (124) adjacent to each other; irradiating the second region (124) by using the photomask to change properties of a film layer of the irradiated second region (124); and etching the first region (114) and the second region (124) by using a same etching process, wherein an etching rate of the first region (114) is less than an etching rate of the second region (124) during the etching process, so that part of the second region (124) is retained when removing the first region (114), to form the second mask layer (104) having the opening.

10. The method according to claim 9, wherein
performing the first patterning treatment on the initial mask layer (102) comprises: etching the first mask layer (103) by taking the second mask layer (104) having the opening as a mask to form the first mask layer (103) having the opening; and etching the initial mask layer (102) by taking the first mask layer (103) having the opening as a mask.

## Patentansprüche

1. Verfahren zum Herstellen einer Halbleiterstruktur, umfassend:
Bereitstellen eines Substrats (100);
Bilden einer Halbleiterschicht (101) auf dem Substrat (100);
Durchführen von P-Typ-Dotierung auf der Halbleiterschicht (101), um die Halbleiterschicht (101) in eine anfängliche Maskenschicht (102) umzuwandeln;
Durchführen einer ersten Strukturierungsbehandlung auf der ursprünglichen Maskenschicht (102), um eine Maskenschicht (112) mit einer Öffnung zu bilden;
und Durchführen einer zweiten Strukturierungsbehandlung auf dem Substrat (100) durch Verwenden eines Ätzprozesses mit der Maskenschicht (112) als Maske, wobei eine Ätzrate des Substrats (100) größer ist als eine Ätzrate der Maskenschicht (112) während des Ätzprozesses;
wobei
ein Material der anfänglichen Maskenschicht (102) eine Bor-Silizium-Verbindung umfasst, und ein Atomprozentsatz von Boratomen und Siliziumatomen in der Bor-Silizium-Verbindung in einem Bereich von 1:1 bis 3:2 ist;
wobei ein Bereitstellen des Substrats (100) Folgendes umfasst:
Bereitstellen einer Basis (110);
Bilden einer gestapelten Struktur (120) auf der Basis (110), wobei die gestapelte Struktur (110) eine untere Trägerschicht (130), eine erste dielektrische Schicht (140), eine mittlere Trägerschicht (150), eine zweite dielektrische Schicht (160) und eine obere Trägerschicht (170) umfasst, die nacheinander auf der Basis (110) gestapelt sind; und
ein Durchführen der zweiten Strukturierungsbehandlung auf dem Substrat (100) Folgendes umfasst:
Ätzen der gestapelten Struktur (120) unter Verwendung der Maskenschicht (112) als Maske und Verwendung des Ätzprozesses zum Bilden eines Kondensatorkontaktlochs (121).

2. Verfahren nach Anspruch 1, wobei
die erste Maskenschicht (102) einen Extinktionskoeffizienten von weniger als 0,45 aufweist.

3. Verfahren nach Anspruch 2, wobei
der Extinktionskoeffizient der ersten Maskenschicht (102) in einem Bereich von 0,34 bis 0,44 ist.

4. Verfahren nach Anspruch 1, wobei
die anfängliche Maskenschicht (102) eine Stärke in dem Bereich von 400 nm bis 460 nm entlang einer Richtung von Substrat (100) zur anfänglichen Maskenschicht (102) aufweist.

5. Verfahren nach Anspruch 1, wobei
nach Durchführen der zweiten Strukturierungsbehandlung auf dem Substrat (100) unter Verwendung des Ätzprozesses ein Teil der Maskenschicht zurückgehalten wird und ein Verhältnis einer Stärke der zurückgehaltenen Maskenschicht (112) zu einer Stärke der anfänglichen Maskenschicht (112) entlang einer Richtung von Substrat (100) zur anfänglichen Maskenschicht (102) in einem Bereich von 0,13 bis 0,16 ist.

6. Verfahren nach Anspruch 5, wobei
die Stärke der beibehaltenen Maskenschicht (112) in einem Bereich von 65 nm bis 75 nm entlang der Richtung von Substrat (100) zur anfänglichen Maskenschicht (102) ist.

7. Verfahren nach Anspruch 1, wobei
ein Bilden der Halbleiterschicht (101) Folgendes umfasst: Bilden einer anfänglichen Halbleiterschicht (111) auf dem Substrat (100); und Durchführen einer N-Typ-Dotierung oder P-Typ-Dotierung auf der anfänglichen Halbleiterschicht (111), um die anfängliche Halbleiterschicht (111) in die Halbleiterschicht (101) umzuwandeln.

8. Verfahren nach Anspruch 1, wobei
die anfängliche Maskenschicht (102) mit einer photolithographischen Markierung versehen ist, wobei während der ersten Strukturierungsbehandlung auf der anfänglichen Maskenschicht (102) unter Verwendung eines ersten Ätzprozesses das Verfahren ferner Folgendes umfasst: Bereitstellen einer Photomaske mit der Öffnung und der photolithographischen Markierung, wobei die photolithographische Markierung der Photomaske mit der photolithographischen Markierung der anfänglichen Maskenschicht (102) überlappt wird.

9. Verfahren nach Anspruch 8, wobei
nach Bilden der anfänglichen Maskenschicht (102) auf dem Substrat (100) und vor Durchführen der ersten Strukturierungsbehandlung an der anfänglichen Maskenschicht (102), das Verfahren ferner Folgendes umfasst: Bilden einer ersten Maskenschicht (103) und einer zweiten Maskenschicht (104), die nacheinander an einer vom Substrat (100) abgewandten Seite der anfänglichen Maskenschicht (102) gestapelt sind, wobei die zweite Maskenschicht einen ersten Bereich (114) und einen zweiten Bereich (124) umfasst, die aneinander angrenzen; Bestrahlen des zweiten Bereichs (124) unter Verwendung der Fotomaske, um die Eigenschaften einer Filmschicht des bestrahlten zweiten Bereichs (124) zu ändern; und Ätzen des ersten Bereichs (114) und des zweiten Bereichs (124) unter Verwendung desselben Ätzprozesses, wobei eine Ätzrate des ersten Bereichs (114) geringer ist als eine Ätzrate des zweiten Bereichs (124) während des Ätzprozesses, so dass ein Teil des zweiten Bereichs (124) beim Entfernen des ersten Bereichs (114) erhalten bleibt, um die zweite Maskenschicht (104) mit der Öffnung zu bilden.

10. Verfahren nach Anspruch 9, wobei
Durchführen der ersten Strukturierungsbehandlung an der anfänglichen Maskenschicht (102), umfassend: Ätzen der ersten Maskenschicht (103), indem die zweite Maskenschicht (104) mit der Öffnung als eine Maske genommen wird, um die erste Maskenschicht (103) mit der Öffnung zu bilden; und Ätzen der anfänglichen Maskenschicht (102), indem die erste Maskenschicht (103) mit der Öffnung als eine Maske genommen wird.

## Revendications

1. Procédé de fabrication d'une structure semi-conductrice, comprenant :
la fourniture d'un substrat (100) ;
la formation d'une couche semi-conductrice (101) sur le substrat (100) ;
la réalisation d'un dopage de type P sur la couche semi-conductrice (101) pour transformer la couche semi-conductrice (101) en une couche de masque initiale (102) ;
la réalisation d'un premier traitement de structuration sur la couche de masque initiale (102) pour former une couche de masque (112) avec une ouverture ;
et la réalisation d'un second traitement de structuration sur le substrat (100) en utilisant un processus de gravure avec la couche de masque (112) comme masque, dans lequel une vitesse de gravure du substrat (100) est supérieure à une vitesse de gravure de la couche de masque (112) au cours du processus de gravure ;
dans lequel
un matériau de la couche de masque initiale (102) comprend un composé bore-silicium, et un pourcentage atomique d'atomes de bore et d'atomes de silicium dans le composé bore-silicium est compris entre 1:1 et 3:2 ;
dans lequel la fourniture du substrat (100) comprend :
la fourniture d'une base (110) ;
la formation d'une structure empilée (120) sur la base (110), dans lequel la structure empilée (110) comprend une couche de support inférieure (130), une première couche diélectrique (140), une couche de support intermédiaire (150), une deuxième couche diélectrique (160) et une couche de support supérieure (170) empilées en séquence sur la base (110) ; et
l'exécution du second traitement de structuration sur le substrat (100) comprend :
la gravure de la structure empilée (120) en prenant la couche de masque (112) comme masque et en utilisant le processus de gravure pour former un trou de contact de condensateur (121).

2. Procédé selon la revendication 1, dans lequel
la couche de masque initiale (102) présente un coefficient d'extinction inférieur à 0,45.

3. Procédé selon la revendication 2, dans lequel
le coefficient d'extinction de la couche de masque initiale (102) est compris entre 0,34 et 0,44.

4. Procédé selon la revendication 1, dans lequel
la couche de masque initiale (102) présente une épaisseur comprise entre 400 nm et 460 nm le long d'une direction allant du substrat (100) à la couche de masque initiale (102).

5. Procédé selon la revendication 1, dans lequel
après avoir effectué le second traitement de structuration sur le substrat (100) en utilisant le processus de gravure, une partie de la couche de masque est conservée, et un rapport entre l'épaisseur de la couche de masque conservée (112) et l'épaisseur de la couche de masque initiale (112) le long d'une direction allant du substrat (100) à la couche de masque initiale (102) se situe dans une plage de 0,13 à 0,16.

6. Procédé selon la revendication 5, dans lequel
l'épaisseur de la couche de masque retenue (112) est comprise entre 65 nm et 75 nm dans la direction allant du substrat (100) à la couche de masque initiale (102).

7. Procédé selon la revendication 1, dans lequel
la formation de la couche semi-conductrice (101) comprend : la formation d'une couche semi-conductrice initiale (111) sur le substrat (100) ; et l'exécution d'un dopage de type N ou de type P sur la couche semi-conductrice initiale (111) pour transformer la couche semi-conductrice initiale (111) en couche semi-conductrice (101).

8. Procédé selon la revendication 1, dans lequel
la couche de masque initiale (102) est pourvue d'une marque de photolithographie, dans lequel, au cours du premier traitement de structuration sur la couche de masque initiale (102) à l'aide d'un premier processus de gravure, le procédé comprend en outre : la fourniture d'un photomasque doté de l'ouverture et de la marque de photolithographie, dans lequel la marque de photolithographie du photomasque est superposée à la marque de photolithographie de la couche de masque initiale (102).

9. Procédé selon la revendication 8, dans lequel
après avoir formé la couche de masque initiale (102) sur le substrat (100) et avant d'effectuer le premier traitement de structuration sur la couche de masque initiale (102), le procédé comprend en outre : la formation d'une première couche de masque (103) et d'une deuxième couche de masque (104) empilées en séquence sur un côté, loin du substrat (100), de la couche de masque initiale (102), dans lequel la deuxième couche de masque comprend une première région (114) et une deuxième région (124) adjacentes l'une à l'autre ; l'irradiation de la deuxième région (124) en utilisant le photomasque pour modifier les propriétés d'une couche de film de la deuxième région irradiée (124) ; et la gravure de la première région (114) et de la deuxième région (124) en utilisant le même processus de gravure, dans lequel une vitesse de gravure de la première région (114) est inférieure à une vitesse de gravure de la deuxième région (124) pendant le processus de gravure, de sorte qu'une partie de la deuxième région (124) est conservée lors de l'enlèvement de la première région (114), pour former la deuxième couche de masque (104) dotée de l'ouverture.

10. Procédé selon la revendication 9, dans lequel
l'exécution du premier traitement de structuration sur la couche de masque initiale (102) comprend : la gravure de la première couche de masque (103) en prenant la deuxième couche de masque (104) dotée de l'ouverture comme masque pour former la première couche de masque (103) dotée de l'ouverture ; et la gravure de la couche de masque initiale (102) en prenant la première couche de masque (103) dotée de l'ouverture comme masque.
